# EUROPEAN PATENT APPLICATION

(11) **EP 1 786 098 A1**
(43) Date of publication of application: **16.05.2007**
(21) Application number: 06255743.4
(22) Date of filing: 08.11.2006
(51) Int. Cl.: H03G 1/00

(54) **Automatic compensation of gain versus temperature**

(30) Priority: 10.11.2005 US 270934
(71) Applicant: TEKTRONIX, INC., Beaverton, OR 97077 (US)
(72) Inventor: Hickman, Barton T., Portland, Oregon 97229 (US)
(74) Representative: Burke, Steven David

(57) **Abstract**

An apparatus and method of automatically compensating gain versus temperature in a circuit of a measurement instrument that is subject to gain drift with temperature senses an ambient temperature for the circuit as a temperature voltage. The temperature voltage is scaled by a settable value representing a known temperature/gain characteristic for the circuit to produce a temperature correction voltage. The temperature correction voltage is subtracted from a reference voltage representing a gain for the circuit to produce a corrected reference voltage for the circuit.

## Description

### BACKGROUND OF THE INVENTION

The present invention relates to control of measurement instruments, and more particularly to automatic compensation of gain versus temperature in an oscilloscope.

Gain accuracy is an important parameter in a measurement instrument, such as an oscilloscope, because it contributes to the quality of the measurements. Presently manufacturers typically recommend that the measurement instrument be re-calibrated whenever ambient temperature of the environment changes by more than five degrees Centigrade in order to maintain gain accuracy within stated specifications. The specified accuracy of many instruments is therefore limited by how much the gain of the instrument changes over temperature. The actual gain accuracy is further limited by how reliably the instrument user remembers to actually run the calibration routine, which in some cases requires over one minute to run. Another disadvantage of re-calibrating is that the gain of the input channel may suddenly change after calibration is completed which may lead to measurement fluctuations that are inexplicable from the user's standpoint. The result is that the instrument may not stay within specification between calibrations.

What is desired is a method of automatically compensating of gain versus temperature between instrument re-calibrations to avoid measurement fluctuations and maintain instrument specifications between calibrations.

### BRIEF SUMMARY OF THE INVENTION

Accordingly the present invention provides for automatic compensation of gain versus temperature in a circuit of a measurement instrument that is subject to gain drift with temperature. A temperature sensor detects an ambient temperature for the circuit as a temperature voltage. The temperature voltage is scaled by a settable value representing a known temperature/gain characteristic for the circuit to produce a temperature correction voltage. The temperature correction voltage is subtracted from a reference voltage representing a gain for the circuit to produce a corrected reference voltage for the cricuit. The automatic compensation occurs continuously in the background without user intervention or interference with signal processing by the circuit.

The objects, advantages and other novel features of the present invention are apparent from the following detailed description when read in light of the appended claims and attached drawing.

### BRIEF DESCRIPTION OF THE SEVERAL VIEWS OF THE DRAWING

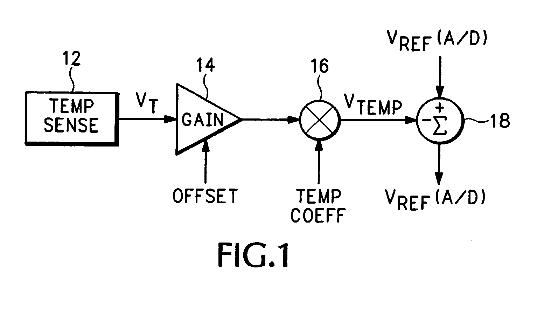

Fig. 1 is a block diagram view of a circuit for automatic compensation of gain versus temperature according to the present invention.

### DETAILED DESCRIPTION OF THE INVENTION

Referring now to Fig. 1 a temperature sensor 12 detects the ambient temperature of a region in an instrument that is representative of the temperature of a circuit whose gain drift is being compensated, and provides a voltage output Vₜ. The temperature voltage Vₜ is input to an amplifier 14 where it is adjusted both in gain and offset to be within the dynamic range of an ensuing multiplier 16. The multiplier 16 scales the adjusted temperature voltage by a settable value that is dependent upon a temperature/gain characteristic for the instrument, or more precisely for the circuit that is being compensated. The settable value determines the amount of gain control adjustment versus temperature. For an instrument input channel that has a negative temperature/gain characteristic, the settable value is set positive. The greater the negative temperature/gain characteristic, the more positive the settable value. The output from the multiplier 16 is a correction voltage Vₜₑₘₚ that is subtracted in a summing circuit 18 from a reference voltage V_{ref} for the device whose gain control is being compensated. For illustration the reference voltage V_{ref} is one applied to analog to digital converters (ADCs) in an input channel path of an oscilloscope. As the temperature increases, the gain of the input channel goes down. To cancel this effect the ADC reference voltages are decreased as the temperature increases. As the ambient temperature increases, the value of Vₜₑₘₚ increases. Subtracting Vₜₑₘₚ from V_{ref} causes V_{ref} to decrease - exactly what is needed to correct the temperature variation.

Although the above example applies the temperature compensation to the reference voltages of the ADCs in the input channels, the correction voltage may alternatively be applied to a variable gain control of input channel preamplifiers. Also the temperature may be sensed digitally and the digital values input to a microcontroller that continuously adjusts the gain control, i.e., any gain control in the input channel. The settable value may be empirically derived during instrument design since generally instruments of the same type have essentially the same temperature/gain characteristics. However where there is the possibility of variations in temperature/gain characteristics from instrument to instrument, the particular temperature/gain characteristics of each instrument may be determined during manufacturing testing.

The example described above describes the situation where the gain drift versus temperature is linear - in such a case only one settable value representing a single temperature coefficient as the temperature/gain characteristic is needed. However more generally temperature drift may also be compensated for non-linear changes in gain versus temperature. In the non-linear case there is more than one settable value - one for each coefficient in a suitable gain correction equation representing the non-linear temperature/gain characteristic. Implementation of the non-linear case is straightforward using a microcontroller. An analog implementation is more complex, requiring more multipliers in cascade.

Thus the present invention provides automatic compensation of gain versus temperature by measuring ambient temperature and adjusting the gain control of an circuit subject to gain drift with temperature based upon a known temperature/gain characteristic for the circuit so that the actual circuit gain is more stable. This process happens automatically in the background so no user intervention is required nor is data acquisition interrupted - 100% "live" time; happens continuously so the circuit gain remains nearly constant; enables the instrument specifications to be set tighter; decreases the frequency of calibrations; and allows relaxation of temperature stability requirements of the circuitry which reduces design time or allows tradeoffs more favorable to other specifications such as noise or bandwidth.

## Claims

1. An apparatus for automatic correction of gain versus temperature comprising:
means for sensing an ambient temperature of a circuit subject to gain drift with temperature; and
means for correcting a gain for the circuit as a function of the ambient temperature and a known temperature/gain characteristic for the circuit.

2. The apparatus as recited in claim 1 wherein the correcting means occurs continuously.

3. The apparatus as recited in claim 1 wherein the correcting means comprises:
means for multiplying a temperature voltage representing the ambient temperature by a settable value representing the known temperature/gain characteristic to produce a temperature correction voltage; and
means for combining the temperature correction voltage with a reference voltage that determines the gain for the circuit to produce a corrected reference voltage.

4. The apparatus as recited in claim 3 wherein the settable value comprises a positive value when the known temperature/gain characteristic is negative.

5. The apparatus as recited in claim 3 wherein the settable value comprises a negative value when the known temperature/gain characteristic is positive.

6. The apparatus as recited in claim 3 wherein the combining means comprises means for subtracting the temperature correction voltage from the reference voltage to produce the corrected reference voltage.

7. The apparatus as recited in claim 3 wherein the combining means further comprises means for adjusting a gain and offset for the temperature voltage prior to input to the multiplying means.

8. A method of automatic correction of gain versus temperature comprising:
sensing an ambient temperature of a circuit subject to gain drift with temperature; and
correcting a gain for the circuit as a function of the ambient temperature and a known temperature/gain characteristic for the circuit.

9. The method as recited in claim 8 wherein correcting step occurs continuously.

10. The method as recited in claim 8 wherein the correcting step comprises the steps of:
multiplying a temperature voltage representing the ambient temperature by a settable value representing the known temperature/gain characteristic to produce a temperature correction voltage; and
combining the temperature correction voltage with a reference voltage that determines the gain for the circuit to produce a corrected reference voltage.

11. The method as recited in claim 10 wherein the settable value comprises a positive value when the known temperature/gain characteristic is negative.

12. The method as recited in claim 10 wherein the settable value comprises a negative value when the known temperature/gain characteristic is positive.

13. The method as recited in claim 10 wherein the combining step comprises the step of subtracting the temperature correction voltage from the reference voltage to produce the corrected reference voltage.

14. The method as recited in claim 10 wherein the combining step further comprises the step of adjusting a gain and offset for the temperature voltage prior to input to the multiplying step.

15. An apparatus for automatically correcting gain versus temperature comprising:
a temperature sensor for detecting an ambient temperature of a circuit subject to gain drift with temperature, the detected ambient temperature being output as a temperature voltage;
a multiplier having as inputs the temperature voltage and a settable value representing a known temperature/gain characteristic for the circuit and producing as an output a temperature correction voltage; and
a subtractor having as inputs the temperature correction voltage and a reference voltage representing a gain for the circuit and providing as an output a corrected reference voltage for the circuit.

16. The apparatus as recited in claim 15 wherein the settable value comprises a positive value when the known temperature/gain characteristic is negative.

17. The apparatus as recited in claim 15 wherein the settable value comprises a negative value when the known temperature/gain characteristic is positive.

18. The apparatus as recited in claim 15 further comprising an amplifier having as inputs the temperature voltage and an offset value and having as an output an adjusted temperature voltage for input to the multiplier as the temperature voltage.
